# EUROPEAN PATENT APPLICATION

(11) **EP 1 915 042 A2**
(43) Date of publication of application: **23.04.2008**
(21) Application number: 07019912.0
(22) Date of filing: 11.10.2007
(51) Int. Cl.: H05K 5/00

(54) **Hermetically sealed circuit**

(30) Priority: 16.10.2006 DK 200601342
(71) Applicant: Ferroperm-Emc ApS, 3000 Helsingør (DK)
(72) Inventor: Holm, Jens Peter, 3050 Humlebæk (DK)
(74) Representative: Siiger, Joergen

(57) **Abstract**

Hermetically sealed circuit, for instance a filter circuit with connection terminals 2, which are led out. A disadvantage of the known hermetically sealed circuits is that they are very sensitive to the temperature gradients, which typically occur at soldering into the bush. Thus, the seal may not be hermetic, when it has been subjected to temperatures above 500 °C. According to the invention, a seal has been provided, which is also hermetic, even though it has been subjected to temperatures above 500 °C. The circuit is characterised in that it is sealed in a silver bush 1, and in that the protruding connection terminals 2 at the ends of the bush 1 are sealed by means of a bevel ring 3 of aluminium oxide, said ring being soldered to the connection terminal 2 and the inside of the bush 1 respectively. By this, a seal is obtained, which is hermetic, also against permeation of helium. In addition to the bevelling 3a, 3b providing space for the soldering material, the bevelling also has the effect that the distance to be covered by e.g. permeating helium will be longer, whereby the risk of permeation will be proportionately smaller, if there is any risk of helium permeation at all.

## Description

The invention relates to a hermetically sealed circuit, for instance a filter circuit with connection terminals, which are led out.

Today, hermetically sealed filters are manufactured by supplying a bush containing the filter with a hermetic seal made by "kovar-glas-kovar". These seals are relatively expensive. In addition, they are difficult to use, as they are very sensitive to the temperature gradients, which typically occur when soldering into the bush. Thus, the seal is not hermetic, when subjected to high temperatures, such as temperatures above 500 °C, which are the temperatures normally occurring in connection with soldering.

The object of the invention is to provide a seal, which is hermetically tight against gasses, such as helium, even though it has been subjected to relatively high temperatures, such as temperatures above 500 °C.

According to the invention, a hermetically sealed circuit of the initially said type is extraordinary in that it is sealed in a bush, preferably a silver bush, and in that the protruding connection terminals at the ends of the bush are sealed by means of a bevel ring of aluminium oxide or a material similar to aluminium oxide, said ring being soldered to the connection terminal and the inside of the bush respectively, and in that prior to the soldering the bevelled surfaces are coated with a binding layer of titanium, which is gilded subsequently.

As a result, a seal is obtained, which is hermetic, also against helium, even though the seal has been subjected to high temperatures. In addition to the bevelling providing space for the soldering material, the bevelling also has the effect that the distance to be covered by e.g. helium will be longer, whereby the risk of helium permeation will be proportionately smaller, if there is any risk of helium permeation at all.

According to the invention, the ring of aluminium oxide can furthermore be bevelled both on the inside and on the outside.

Furthermore, the bevelling angle can, according to the invention, be approx. 45°.

The invention also relates to a method for manufacturing of a hermetically sealed circuit with connection terminals. According to the invention the method is extraordinary in that the circuit is placed in a silver bush with the connection terminals being led out at the ends of the bush, whereupon a bevelled sealing ring of aluminium oxide is placed around the individual connection terminal, said ring being soldered to the connection terminal and the inside of the silver bush respectively, and in that prior to the soldering the bevelled surfaces are coated with a binding layer of titanium, which is potentially protected against oxidizing by means of a relatively thin layer of gold. The bevelling has the effect that it becomes relatively easy to provide the sealing by means of simple soldering or another kind of soldering such as brazing.

Finally, a silver layer may be electroplated onto the gold layer.

The invention is explained in detail below with reference to the drawing, in which
Figure 1 shows a hermetically sealed filter circuit, partly in sectional view.
Figure 2 a sealing ring for the hermetically sealed circuit,
Figure 3 the components of a π-filter and the appurtenant diagram, and
Figure 4 the components of a T-filter and the appurtenant diagram.

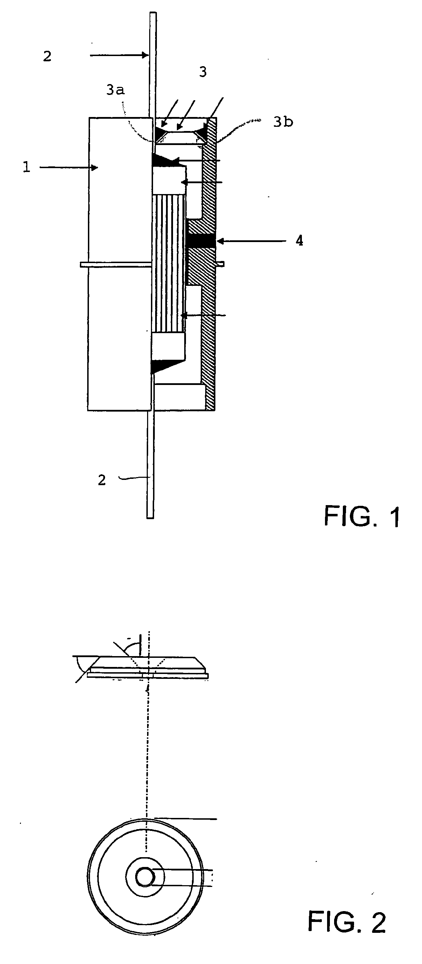

The hermetically sealed circuit shown in Figure 1 is sealed in a bush 1, such as a silver bush, an electroplated bush, a gilded bush or other material combinations, where there are protruding connection terminals 2 at the ends of the bush. The connection terminals 2 are sealed by means of a bevel ring 3 of aluminium oxide. This ring 3 is soldered to the connection terminal 2 and the inside of the bush 1 respectively, where a circumferential incision is provided, in which the bevel ring 3 may rest. The aluminium oxide ring 3 is bevelled both on the inside and on the outside, and the bevelling angle is 20-70°, preferably 45°. Prior to the soldering, the bevelled surfaces 3a and 3b are coated with a binding layer of titanium having a thickness of approx. 50 µm. The titanium layer is protected against oxidizing by a gold layer having a thickness of approx. 1 nm. A silver layer having a thickness of approx. 10 µm is applied onto said gold layer. The even side of the aluminium oxide ring is abraded, so that an aluminium oxide ring 3 with two small titanium/gold/silver rings is obtained, see Figure 2.

By this, a seal is obtained after the soldering to the connection terminal 2 and the inside of the silver bush 1 respectively, said seal being hermetic, also against helium. In addition to the bevelling providing space for the soldering material, the bevelling 3a and 3b also has the effect that the distance to be covered by potentially permeating helium will be longer, approx. √2 times longer, when the bevelling angle is 45°. By this, the risk of permeation is decreased proportionally, if there is a risk of permeation of e.g. helium at all.

Figure 2 shows the bevel ring from the side and above respectively.

Figure 1 also shows a high temperature soldering 4.

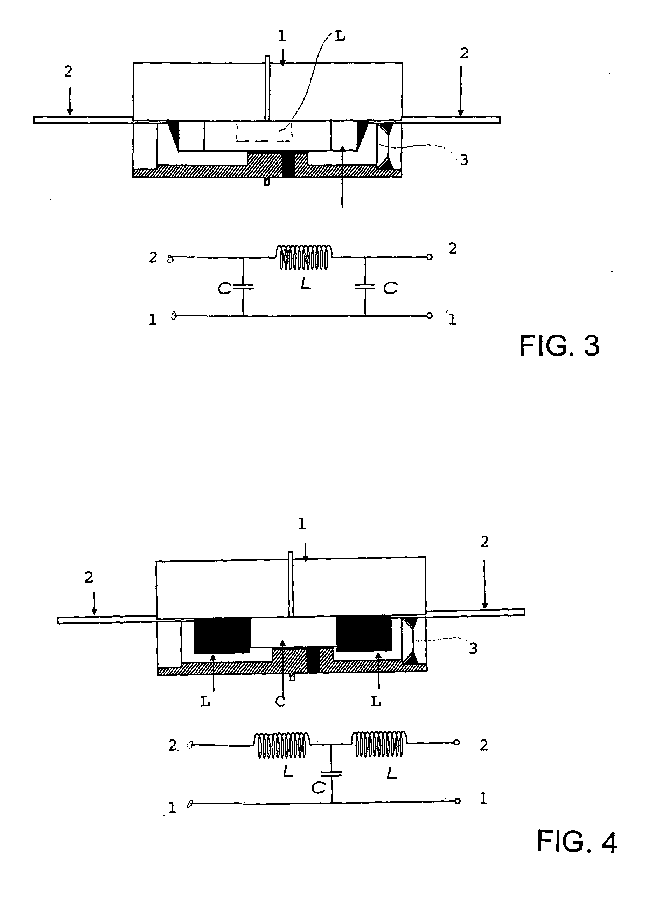

Figure 3 shows the components of a π-filter and the corresponding electrical diagram. The π-filter includes an inductor L connected to the input and output terminal 1, 2 respectively, where both terminals are earthed through a capacitor C. The inductor L may have a value of 1 µH, whereas the capacities C may have a value of 2n F. The silver cylinder ensures the earthing.

Figure 4 shows the components of a T-filter and the corresponding electrical diagram. Two inductors, connected in series, are connected to the input and output terminal 1, 2 respectively, whereas the tie point between the inductors is earthed through a capacitor. The surrounding silver cylinder ensures the earthing. The inductors may each have a value of 0.5 µH, whereas the capacitor may have a value of 2 µF.

The sealing ring 3 may have an outside diameter of 3.7 mm, whereas the hole of the sealing ring may have a diameter of 0.85 mm.

The sealed circuit is not necessarily a filter circuit. Other circuits are possible.

## Claims

1. Hermetically sealed circuit, for instance a filter circuit with connection terminals (2), which are led out, **characterised in that** it is sealed in a bush (1), preferably a silver bush, and **in that** the protruding connection terminals (2) at the ends of the bush (1) are sealed by means of a bevel ring (3) of aluminium oxide or a material similar to aluminium oxide, said ring being soldered to the connection terminal (2) and the inside of the bush (1) respectively, and **in that** prior to the soldering the bevelled surfaces are coated with a binding layer of titanium, which is gilded subsequently.

2. Circuit according to claim 1, **characterised in that** the ring (3) of aluminium oxide is bevelled on the inside and/or on the outside.

3. Circuit according to claim 2, **characterised in that** the bevelling angle is approx. 45°.

4. Method for manufacturing of a hermetically sealed circuit with protruding connection terminals (2), **characterised in that** the circuit is placed in a silver bush (1) with the connection terminals (2) being led out at the ends of the bush (1), whereupon a bevelled sealing ring (3) of aluminium oxide is placed around the individual connection terminal (2), said ring (3) being soldered to the connection terminal (2) and the inside of the silver bush (1) respectively, and **in that** prior to the soldering the bevelled surfaces are coated with a binding layer of titanium, which is potentially protected against oxidizing by means of a relatively thin layer of gold.

5. Method according to claim 4, **characterised in that** prior to the soldering the bevelled surfaces are coated with a binding layer of titanium.

6. Method according to claim 5, **characterised in that** a silver layer is electroplated onto the gold layer.
